**Europäisches Patentamt**

**European Patent Office**

**Office européen des brevets**

(11) Publication number: **0 308 266**
**A2**

# EUROPEAN PATENT APPLICATION

(21) Application number: **88308627.4**

(22) Date of filing: **16.09.88**

(51) Int. Cl.⁴: **H 01 L 39/12**
**H 01 L 39/24**

(30) Priority: **16.09.87 JP 231884/87**
**16.09.87 JP 231885/87**
**16.09.87 JP 231887/87**

(43) Date of publication of application:
**22.03.89 Bulletin 89/12**

(84) Designated Contracting States: **DE FR GB**

(71) Applicant: **SEL SEMICONDUCTOR ENERGY
LABORATORY CO., LTD.
398 Hase
Atsugi-shi Kanagawa-ken 243 (JP)**

(72) Inventor: **Yamazaki, Shunpei
21-21 Kitakarasuyama 7-chome
Setagaya-ku Tokyo (JP)**

(74) Representative: **Milhench, Howard Leslie et al
R.G.C. Jenkins & Co. 26 Caxton Street
London SW1H 0RJ (GB)**

(54) Method and apparatus for forming superconducting materials.

(57) A method and apparatus is disclosed for the formation of thin film superconducting oxide materials, for example materials of the general formula $(A_{1-x}B_x)_yCu_zO_w$, by deposition onto a substrate of the reaction products of a microwave excited plasma subjected additionally to a magnetic field and with the deposition being effected again under the action of magnetic and/or electric fields directed so as to obtain preferential crystal orientation and in some cases epitaxial crystal growth in the deposited film. By use of microwave excitation a hybrid resonance is established within the plasma leading to an abundance of excited oxygen within the plasma whereby the introduction of elemental constituents of the required superconducting oxide material, preferably in aerosol or spray form, can result in a plasma reaction wherein the superconducting material is the reaction product. If a spoiling agent is introduced additionally into the plasma in the first part of a two part process, a non-superconducting film of essentially the same crystal structure and crystal orientation as the required film can be deposited to form a surface for formation of the desired superconducting film.

## Description

# METHOD AND APPARATUS FOR FORMING SUPERCONDUCTING MATERIALS

## BACKGROUND OF THE INVENTION

### Field of the Invention

The present invention relates to improved superconducting oxide materials and to methods for manufacturing such superconducting oxide materials.

### Description of the Related Art

Recently, superconducting ceramics materials have been attracting a great deal of attention. These materials were first reported by IMB's Zurich Laboratories in the form of Ba-La-Cu-O (BALACUO) type high temperature superconducting oxide materials. In addition, YBCO ($YBa_2CuO_{6-8}$) types are also known. However, these known materials could be prepared only by mixing and firing various types of oxide powders to form tablets, so that even when a Tc onset of 90 K was obtained it was not possible to manufacture the required thin film structures exhibiting these properties.

More recent work has enabled superconducting ceramics materials to be formed as thin films, but problems remained that the critical current densities obtainable with the known polycrystalline oxide superconducting structures abovementioned are small and, in addition, because of the large difference between the coefficients of thermal expansion of the superconducting film material and the substrates upon which they are formed, when the superconducting material is formed at temperatures higher than 650°C and especially in the high temperature range of 900 to 950°C, cooling of the superconducting material to the temperature of liquid nitrogen induces cracking and the electrical conductivity is inhibited. For these reasons, there has been a strong requirement to carry out film formation at temperatures of 500°C or lower, so that a greater degree of freedom might be provided in the selection of substrate materials and, furthermore, it has been strongly desired that the Tco (temperature at which resistance is zero) of the superconducting oxide material be higher. It is desirable that superconductivity be possible at the temperature of liquid nitrogen (77 K) or higher and that a Tco temperature of 90 K or higher be available in thin film superconducting structures.

With such objectives in mind, we made the invention which is described in our European Patent Application No. 88302512.4 (EP-A-0284354) and which concerns a method and apparatus for manufacturing a superconducting material wherein a magnetic field is applied to the material during a heating stage in its formation process so that a more ordered superconductor is obtained. The present invention is a further development of the abovementioned invention.

## SUMMARY OF THE INVENTION

In accordance with one aspect of the present invention a thin film superconducting oxide material is prepared by reaction between reactive gases and/or reactive minute particles in a plasma subject to a magnetic field and by deposition upon a surface subject to the magnetic field so that a preferred crystal orientation is obtained during the formation of the film.

More particularly, in accordance with the abovementioned aspect of the present invention there is provided a method of forming a superconducting oxide material, said method comprising: introducing oxygen or an oxidizing gas and a reactive gas or reactive minute particles into a plasma generating chamber; applying a magnetic field to the plasma generating chamber and supplying microwave energy to the plasma generating chamber, the direction of the magnetic field and the propagation direction of the microwave energy being parallel; the mutual reaction of the oxygen or the oxidizing gas and the reactive gas or reactive minute particles converting them to plasma; and forming the superconducting oxide material by deposition of the plasma reaction products on a film forming surface portion positioned in or adjacent to the plasma generating chamber and subjected to the application of a magnetic field.

The invention furthermore extends to an apparatus for forming a superconducting oxide material, said apparatus comprising: a plasma generating chamber; means for generating a magnetic field within the plasma generating chamber; means for supplying microwave energy to the plasma generating chamber; means for supplying a reactive gas or reactive minute particles and oxygen or an oxidizing gas to the plasma generating chamber for forming a superconducting oxide material as a plasma reaction product; and means for forming the superconducting oxide material on a film-forming surface portion provided in the plasma generating chamber or in a region adjacent thereto, while applying a magnetic field or an electrical field thereto.

Differently stated, the invention thus provides a method of forming a superconducting oxide material comprising: applying a magnetic field to the inside of a reaction chamber; propagating microwave energy into the reaction chamber in substantially the same direction as the magnetic field; generating a microwave excitation reaction wherein a superconducting material is formed in a resonance space by means of the resonance of the microwaves with a reactive gas or reactive minute particles in the magnetic field; and growing crystals of the superconducting oxide material with the atomic arrangement of the crystals regulated by means of the magnetic field.

In accordance with another aspect of the present invention there is provided a method of forming a superconducting film, said method comprising forming a non-superconducting film of substantially the same crystalline structure as the required superconducting film, and then forming the superconducting film on the surface of the non-superconducting film.

According to this second aspect of the invention, and independently in accordance with a third aspect of the invention, in the formation of a superconducting film by deposition of plasma reaction products upon a substrate or film-forming surface, a spoiling additive is preferably introduced into the plasma so as to spoil the superconducting properties of the deposited film, and thereafter a superconducting film is formed without the additive.

More particularly, in accordance with the abovementioned second and third aspects of the invention, there is provided a method of forming a superconducting oxide material wherein first a film with non-superconducting characteristics is formed from the same main constituents as the superconducting oxide material, said method comprising: the introduction into a plasma generating chamber of oxygen or an oxidizing gas and a reactive gas or reactive minute particles for forming a superconducting oxide material; the introduction into the plasma generating chamber of a reactive gas or reactive minute particles as an additive for destroying the superconducting characteristics of the superconducting oxide material; the application of a magnetic field to the plasma generating chamber; the supplying of microwave energy to the plasma generating chamber; the mutual reaction of the oxygen or oxidizing gas and reactive gas or reactive minute particles, and of the additive reactive gas or additive reactive minute particles converting them to a plasma; the formation of a film having non-superconducting characteristics on a film-forming surface portion positioned in or adjacent to the plasma generating chamber and subject to the application of a magnetic field, the non-superconducting film having the same major constituents as the required superconducting oxide material and further including the additive for destroying the superconducting characteristics; and the formation of a superconducting oxide material contiguous to the non-superconducting film by repetition of the abovementioned process with the omission of the additive for destroying the superconducting characteristics.

Preferably, according to the aforementioned inventive aspects, materials for constituting the required superconducting material by plasma reaction for example, and also spoiling materials as appropriate, are introduced into the plasma chamber in the form of an aerosol or spray comprising organic compounds of the constituent elements, or comprising salts of the constituent elements, or comprising finely divided or powdered preformed superconducting material.

Further features of the present invention are set forth in the appended claims and will become clear to those possessed of the relevant skills from consideration of the following description of exemplary embodiments given in conjunction with the accompanying drawings.

BRIEF DESCRIPTION OF THE DRAWINGS

Fig. 1 is one example of the crystal structure of a superconducting oxide material produced in the practice of the present invention; and

Fig. 2 is a diagram showing an apparatus for manufacturing superconducting thin film material in accordance with the present invention.

DETAILED DESCRIPTION OF EXEMPLARY EMBODIMENTS

In the practice of the present invention, a thin film of a superconducting oxide material is prepared by a reaction between reactive gases and/or reactive minute particles within a plasma and under the action of a magnetic field, and simultaneously this magnetic field is applied to the surface portion upon which the thin film is formed (such surface hereinafter being referred to as a "film-forming surface portion") so that a preferred crystal orientation is obtained during the formation of the film.

By virtue of the present invention, it has been found that even if cooling is maintained at the activation (operation) temperature of the resulting superconductor, the difference between the coefficients of thermal expansion of the superconductor and of its underlying support never induce cracking and the like. This is because the formation temperature of the thin film can itself be as low as in the 200 to 500 °C range. Even at such low temperatures, single crystals or polycrystals with the crystal axis uniformly oriented in the prescribed direction are produced in the practice of the present invention.

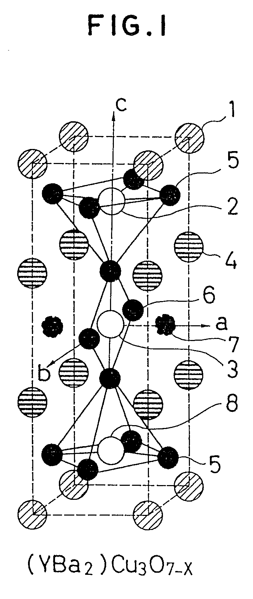

In order to obtain higher critical current density, active oxygen such as $O$, $O_3$ and the like which is produced in a microwave plasma with extremely high efficiency may be used as a reactive gas for manufacturing thin films in accordance with the teachings of the invention. In addition, in order to avoid sputtering (damage) on the film forming surface portion, a plasma CVD method is preferably used as the method of forming the film rather than a sputtering method, with the plasma preferably energized by high frequency (500 MHz to 10 GHz, and typically 2.45 GHz) microwave energy. When the plasma is created in this way in a plasma CVD method, kinetic energy is not imparted to the reactive gas or reactive minute particles. When a thin film of a superconducting oxide material having a modified perovskite structure as shown in Fig. 1 is produced, the magnetic field used in the generation of the plasma is directed parallel or roughly parallel to the a, b, or c axes of the crystal structure. Simultaneously, by means of this magnetic field the film-forming surface portions of the crystals are positioned in a uniform direction, and magnetic axial growth occurs. In addition, in the case where single crystals are grown, magnetic epitaxial growth occurs. As a result, during the formation of a thin film, by the application of the magnetic field of 0.1 T or more used to produce plasma simultaneously to the surface portion, it becomes possible to orient the surface portion at a lower temperature preferably of the order of 200 to 500 °C. Simultaneously, the reactive gas or reactive particles are being mutually subjected to a plasma reaction in active oxygen or a gas containing active oxygen produced by microwave energy, and on the film-forming surface portion the superconducting oxide material reaction product forms film with crystal axes in mutual agreement. By this method, the critical current density in the direction of, for example, the c surface (the surface parallel to the ab axis, specifically the ab surface) is improved to $1 \times 10^5$ A/cm$^2$ or greater (in this case, the ab surface can be in a direction parallel to the surface of the substrate).

An exemplary superconducting oxide material which can be produced in the practice of the present invention is an oxide including elements of Group IIA and Group IIIa of the Japanese Periodic Table and copper. For the avoidance of doubt it is to be noted that all references herein and in the appended claims to the Periodic Table and to specific Groups of the Periodic Table are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and 0 are the same in the Japanese and European Periodic Tables, Groups IIIa, IVa, Va, VIa and VIIa of the Japanese Periodic Table correspond respectively to Groups IIIb, IVb, Vb, VIb and VIIb of the European Periodic Table, and Groups IIIb, IVb, Vb, VIb and VIIb of the Japanese Periodic Table correspond respectively to Groups IIIa, IVa, Va, VIa and VIIa of the European Periodic Table.

The superconducting material of the present invention can be generally represented by the expression $(A_{1-x} B_x)_y Cu_z O_w$, where x = 0.1 to 1, y = 2.0 to 4.0, preferably 2.5 to 3.5, z = 1.0 to 4.0, preferably 1.5 to 3.5, and w = 4.0 to 10.0, preferably 6 to 8. One representative example is a material having a modified perovskite structure represented by the expression $AB_2Cu_3O_{6-8}$. In these expressions A is one or more elements of the yttrium group and the other lanthanides, the yttrium group comprising Y (yttrium), Gd (gadolinium), Yb (ytterbium, Eu (europium), Tb (terrbium), Dy (dysprosium), Ho (holmium), Er (erbium), Tm (thulium), Lu (lutetium) and Sc (scandium), and B is one or more of Ba (barium), Sr (strontium) and Ca (calcium). An example of such a superconducting oxide material comprises $(YBa_2)Cu_3O_{7-x}$ which, as shown in Fig. 1, has a modified perovskite structure. It has a first plane including a copper atom (2) and four neighboring oxygen atoms (5), another plane including a copper atom (3), two oxygen atoms (6) positioned next to it, and two oxygen vacancies (7), and a third plane similar to the first and comprising a copper atom (2') and four oxygen atoms (5'). Reference numeral (1) is an element from Group IIIa of the Japanese Periodic Table, in the present example Y, and reference numeral (4) is an element from Group IIa of the Japanese Periodic table, in the present example, Ba.

The inventor of the present invention suggests as the mechanism which creates superconductivity that by means of the mutual action of oxygen (5), (5') in a layer structure and copper (2), (2') at the centre of the layer, electrons which are paired (electron pairs) can move in ab planes, that is to say planes perpendicular to the c axis of the crystal. Up to this time, mutual action with a phonon has been considered to be the cause of the formation of the paired electrons, based on the BCS (Bardeen-Cooper-Schrieffer) theory. However, the inventor of the present invention suggests that a quasiparticle known as a magnon is created when an oxygen vacancy (7) within the layer structure of Fig. 1 is associated with another oxygen vacancy in the atomic system positioned on the upper or lower side of the diagram or with a rare earth element (1), which is a screw magnetic body, and that the quasiparticle acts as an intermediary to form a pair of electrons spinning in opposite directions. The magnon fluctuates in the c axis direction, this direction favouring the production of electron pairs, and causes the attraction of an otherwise mutually repelling pair of electrons having opposite spin directions. The magnon is not completely in evidence but works behind the scene. The resulting electron pairs move within the a-b planes within the laminar crystal structure, namely the plane including the atoms (2), (5) and the plane including the atoms (2'), (5'). This can be considered as the cause of superconductivity. In addition, it is possible to consider the fluctuations of the oxygen vacancy as a phonon fluctuation, and therefore to have a pattern which supplements the BCS theory and in which it can be considered that the phonon, through the medium of the magnon, indirectly causes the electron pair to form.

Because the magnetic field in this principle of action causes a major effect, a mutual reaction is obtained between a magnetic field and an electric field applied throughout a plasma atmosphere from external sources during film formation to produce a plasma from a reactive gas or from minute reactive particles. Furthermore, the magnetic field used in plasma generation is utilised so that the film-forming surface portion is positioned parallel to or perpendicular to this magnetic field in a strong region thereof whereby all crystals are uniformly positioned in the prescribed direction with their (ab) planes mutually oriented during the formation of the film.

In addition, by the application of a microwave electric field in a direction perpendicular to this magnetic field, specifically in the direction of the ab layer where the current flows during superconductivity, the ease of crystal orientation can be promoted. In particular, by active mutual use of electric and magnetic fields, the reaction pressure need not be the low pressure of $10^{-3}$ to 0.1 torr used in the generally known plasma CVD method or the ECR (electron cyclotron resonance) method of thin film deposition, but can be at an extremely high pressure and high plasma density of 1 to 800 torr, with plasma generation in a possible hybrid resonance region. Here, by carrying out a reaction to completion by mutual use of reactive gas, reactive particles and active oxygen, the reaction products will be oriented along the c axis following the magnetic field and this orientation will correspondingly be fixed when the reaction products are deposited at the film-forming surface portion following the direction of the magnetic field. Thus, it is possible to make the film more easily and there are less restrictions on the type of substrate that can be used.

It is desirable, furthermore, to be able to form a polycrystal film in which the respective crystal axes of the polycrystals are at least substantially aligned in parallel directions by the application of a magnetic field while heating. It is desirable that magnetic epitaxial growth at a low temperature should occur, and more specifically that a single crystal thin film be formed, by using a substrate having a crystal orientation in which the axes of orientation are in agreement with this growth surface. In this case, the superconducting oxide material used in the present invention is obtained from a single crystal film at a low temperature. Furthermore, the critical current densities along the C plane are larger than those normal to the C plane by two or more orders of magnitude. For this reason, when using polycrystals, it is extremely important that polycrystals having scattered crystal orientations be arranged to have the crystal axis positioned in one direction in order to obtain a high critical current density.

The present invention is a method of forming a thin film which forms a superconducting oxide material, wherein an organic reactive spray or aerosol of the starting material elements, finely divided minute particles of a superconducting oxide material produced by preliminary firing the starting material, or minute particles of a salt or salts of the starting elements, are introduced or sprayed into a plasma in which there is an abundance of active oxygen under atmospheric pressure or reduced pressure.

In accordance with the present invention, it was discovered that after formation of the film, during heat annealing in the same reaction furnace as required, a large part or all of the crystals, specifically the crystals which are being arranged as polycrystals, can be made to grow by the application of a magnetic field, which is desirably 0.1 Tesra (T) or greater and typically 0.3 to 5T, in the same direction as this magnetic field or in a rearranged direction close to it. Then it was discovered that crystals aligned in their C axis directions are readily obtained by application of the magnetic field.

In this way a crystal particle developing into a polycrystal can become larger. In turn, because adjacent crystals have the same crystal axis in common, the barriers at crystal boundaries tend to disappear and a quasi-single crystal structure can be obtained. By this means, the respective crystals can all become adjusted at their (ab) planes perpendicular to the C axis. As a result, by the method of the present invention the critical current density, which hitherto has been the order of $10^2$ A/cm$^2$ (measured at 77K) in the case of randomly oriented crystals, can be increased up to $10^4$ to $10^6$ A/cm$^2$ (measured at 77K) with the current flowing parallel to the (ab) plane, and can become equal to that of a single crystal or at least as large as 1/5 that of a single crystal which is a substantial current density for a polycrystalline structure. The invention thus makes it easier to make large area thin films having a near single crystal structure which is ideal for superconducting oxide materials.

In the practice of present invention, in preparing a superconducting thin film with such an axis arrangement, a magnetic field is applied in a perpendicular or horizontal direction with respect to the surface portion on which the thin film material is being created, and by the application in a direction perpendicular to the magnetic field direction of a microwave electric field for generating active oxygen, the temperature at which the film is formed may be effectively lowered.

In addition, it is effective to conform the crystal axis of the substrate constituting the film-forming surface portion to the direction in which it is desired to arrange the orientation of the superconductor crystals by application of the magnetic field. For example, if a crystal substrate of MgO (magnesium oxide), $SrTiO_3$ (strontium titanium oxide), or YSZ (yttrium stabilized zircon) for example, having a (100) direction is used, and a magnetic field is applied in a direction perpendicular to the film-forming surface portion, then it is possible to form the ab) plane of the superconductor parallel to the film-forming surface portion. In addition, if crystal substrates which have a (11) direction are used and a magnetic field is applied parallel to the film-forming surface portion, it is possible to align the (ab) plane of the superconductor perpendicular to the film-forming surface portion by thermal annealing and the application of a magnetic field after the film is formed. By this means it is possible to obtain a single-crystal thin film or to obtain a polycrystal line thin film very similar to a single crystal thin film.

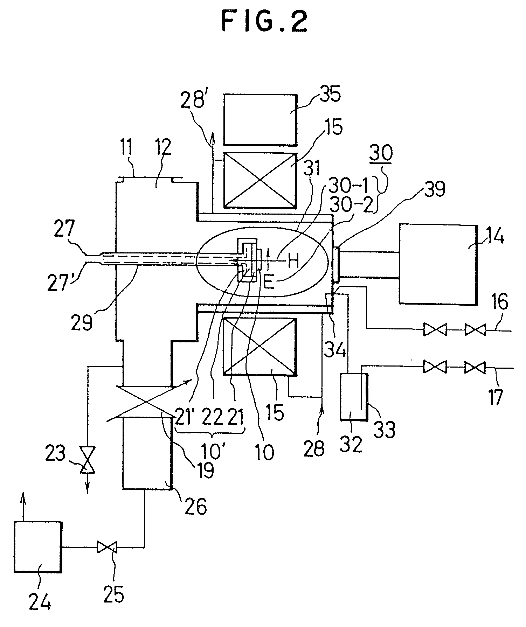

Referring now to Fig. 2, this figure shows a microwave enhanced plasma CVD apparatus incorporating magnetic field generating means, such apparatus being adapted for the production of superconducting thin films in accordance with the present invention.

The apparatus shown in Fig. 2 comprises a plasma generating chamber 31 which can be maintained at atmospheric pressure or at a reduced pressure, an auxiliary space 12, a cylindrical electromagnet 15, a power source 35 for the electromagnet 15, a microwave oscillator 14, a vacuum pump 26 for an exhaust gas system, a rotary pump 24, a pressure adjusting valve 19, a substrate holder 10', a substrate 10 defining a surface upon which a superconducting film is required to be formed, a microwave introduction window 39, a plurality of gas systems 16, 17, a plurality of water cooling systems 28, 28', a rod 29 for removing the substrate 10 and substrate holder 10', and a plurality of water cooling systems 27, 27' extending through the inside of the rod 29 for cooling and maintaining at a suitable temperature the substrate surface portion on which the film is to be formed.

The substrate holder 10' is provided with a buffer layer 21, 21' and a cooling layer 22 to cool the substrate surface which is subjected to the extreme heat of the plasma in the plasma generating chamber 31 to a suitable temperature, and to maintain the substrate surface at a specified temperature of, for example, 200 to 500°C. The cooling layer 22 is formed from iron, nickel, or cobalt, all of which are ferromagmetic materials, and one part is hollow to allow circulation of the cooling water in the system 27, 27'. The buffer layer 21, 21' is formed of a non-magnetic, heat resistant material such as a ceramics material, stainless steel, or glass. The cooling layer 22 of ferromagnetic material concentrates the magnetic field at the surface of the substrate and is shielded from heat by the buffer layer 21, 21' in order to avoid having it reduced to para-magnetism by overheating.

In use of the described apparatus, the substrate 10 upon which a thin film is to be formed is set on the substrate holder 10', and the substate/substrate holder system is positioned in the plasma generating chamber 31 through a gate valve 11. The substrate can, for example, be constituted by a silicon wafer which has an insulating film formed for an IC on one part of its top surface, and substrates of MgO, $SrTiO_3$ or YSZ for example having a (100) or (110) surface crystal orientation can also be used.

When operating at atmospheric pressure, the valve 19 is closed and the valve 23 is opened. When operating under reduced pressure, the valves 19 and 25 are opened and the valve 23 is closed, and the vacuum pump 26 and the rotary pump 24 will be in operation.

A liquid 32 into which reactive materials in solution or as a suspension of fine particles are blended may be enclosed in a bubbler 33, such reactive materials constituting the raw materials for production of the superconducting film. In the case where a chemical vapor reaction method is used, oxygen 17 may be bubbled into the liquid 32 which will be released into the plasma generating chamber 31 through a nozzle 34 with the oxygen. If a spray method is used, the nozzle 34 can be used as a spray nozzle. Oxygen or air can be pressurized and introduced from the gas system 16, and the liquid solution or suspension 32 may be ejected through the nozzle 34 under pressure.

In the apparatus of Fig. 2, one ring-shaped magnet 15 is used for generating the magnetic field 30-1. As a result, in the plasma generating chamber 31 there is a region with a magnetic field strength of 875 gauss ± 185 gauss which has sufficient mutual electric and magnetic field action to support hybrid resonance, and there are other regions which have even greater magnetic field strength. With the substrate 10 positioned in the region which has the maximum magnetic field strength (here, it is the section centered around the magnet 15) and with the magnetic field 30-1 applied perpendicular to the film-forming surface portion on the substrate and the electrical field 30-2 applied parallel to that surface, in accordance with the strength of the magnet 15 a region of 875 gauss which satisfies hybrid resonance conditions can be created in the space between the film-forming surface in the plasma generating chamber 31 and the gas introduction nozzle 34. The material for producing the oxide superconducting film undergoes an activated dissociation reaction in the hybrid resonance region and is formed into a film on the film-forming surface portion of the substrate with the c axis of the film crystal structure aligned in the direction of the magnetic field.

In an exemplary manufacturing process according to the invention, a vacuum of $1 \times 10^{-4}$ Torr or less is first applied to the entire system using the mechanical booster (vacuum) pump 26 and the rotary pump 24. Next, a non-product gas (this is an oxidizing gas which does not itself form a solid body after a chemical vapour decomposition reaction) such as $N_2O$, NO, $NO_2$, air or oxygen, for example, is passed through the 2000 SCCM gas system 16 and introduced into the plasma generating chamber 31 where it is pressurized to 30 Torr. Microwave radiation at a frequency of 500 MHz or greater, for example 2.45 GHz, is injected into the plasma chamber 31 from the microwave oscillator 14 at a strength of from 0.5 to 5 KW, for example 1.5 KW. In addition, by using the magnet 15 which is water-cooled as shown by 28, 28', a magnetic field is generated in the plasma chamber 31 so as to obtain a critical field strength of about 1 T at the surface of the substrate 10. By virtue of this arrangement, a high density plasma exhibiting hybrid resonance is generated in the plasma generating chamber 31. The magnetic field 30-1 and the microwave electric field 30-2 are mutually at right angles. In the drawing, the magnetic field 30-1 is applied in a direction perpendicular to the substrate surface portion on which the film is to be formed. By means of this high density plasma, active oxygen at almost 100% ionization can be created.

Having thus established a highly energized plasma rich in activated oxygen within the plasma chamber 31, the next step is to introduce into the chamber the components of the required superconducting material which are required to react within the energized plasma and produce the deposited thin film, and there are various ways in which this can be effected as will now be described.

In a first method, a solution is formed of organic compounds of the elements which form the superconducting oxide material in the reaction system. For example, alkylated or halogenated compounds such as $Y(OC_2H_5)_3$ (triethoxy yttrium), $Ba(OC_2H_5)_3$ (triethoxy barium), $CuBr_3$ (cupric bromide), and the like, might be dissolved in an organic solution such as benzine or alcohol or the like, or in an aqueous solution, in proportions such that the ratio of Y:Ba:Cu is 1:2:3 after forming the film. Oxygen might then be bubbled through these mixed solutions so that they are introduced throughout the plasma together with oxygen in the form of an aerosol, vapour or spray.

In accordance with another method, ammonia-neutralized salt products such as $YBr_3$, $BaBr_2$, $CuBr_2$ or $Y(NO_3)_3$, $Ba(NO_3)_2$, $Cu(NO_3)_2$ and the like are dissolved in water or organic solutions, and, using the spray method in which oxygen or air is blown into these solutions under high pressure, they are introduced into the reaction chamber. The ratio of oxygen as a carrier gas to the reactive constituents might be in the range of 3000:1 (for example 100:1).

In accordance with yet another method, a previously prepared composition of a superconducting oxide material containing elements from Groups IIa and IIIa of the Japanese Periodic Table and copper may be finely powdered and mixed into a solution, the mixed solution then being atomized by spraying or by the bubbler 33 and released into the plasma generating chamber 31 so that an oxidizing reaction is carried out to completion in the magnetic field space.

When hybrid resonance is obtained within the plasma region by mutual utilization of microwave energy and the magnetic field, the plasma temperature is much higher than the melting temperature of the conducting oxide material (around 1150°C) and can be as high as the 3000 to 10,000 °C range. Under these conditions the reactive atoms are subjected to high energy excitation and are sufficiently activated to form a deposit on the film-forming surface portion of the substrate in an inherent crystal structure. A thin film of superconducting oxide material can be accumulated on the film-forming surface portion of the substrate 10 on the substrate holder 10' which is cooled to a low temperature by the cooling layer 22 so that the temperature of the substrate itself is in the low range of 200 to 500 °C. Then, by annealing at 400 °C after the film is formed, it is possible to form a thin film superconducting oxide material having a modified perovskite rhombic crystal structure with a film thickness of 1 μm to 1 mm.

The critical current density of a superconducting oxide film made as described above was measured at $8.8 \times 10^4$ A/cm$^2$ in a direction parallel to the substrate surface. It was established that the crystal structure shown in Fig. 1 was well formed in the superconducting film both at the time the film was formed and in the subsequent annealing stage. Also, it was apparent from the results of X-ray analyses that the c axis of the film crystal structure was aligned parallel to the magnetic field in the direction perpendicular to the film-forming surface portion of the substrate.

Having thus described a first example of use of the apparatus of Fig. 2 in the manufacture of a thin superconducting film in accordance with the present invention several further examples will now be briefly described.

Example 2

The base chemicals introduced into the plasma chamber were formulated for the deposition of a superconducting material represented by the expression $Y_{0.5}Yb_{0.5}BaSrCu_3O_{6-8}$. The substrate 10 and holder 10' were placed at right angles to the plane of the drawing sheet (in the lateral direction on the drawing) and the substrate was maintained at 500°C. In this way, the c axis of the resultant film could be made to align along the film-forming surface portion, with the ab plane of the superconducting oxide thin film aligned in the perpendicular direction. The other deposition conditions were substantially the same as in the case of Example 1. As a result, a critical current density of $3.6 \times 10^4$ A/cm$^2$ and a Tco of 93 K were obtained for the superconducting oxide thin film which was formed on the film-forming surface portion of, for example, a glass, alumina, or ZrO$_2$ substrate or the like of polycrystal line or amorphous structure.

Example 3

The substrate of Example 1 was changed to a single crystal of MgO (100) or SrTiO$_3$ (100). Then a magnetic field of 2T was applied throughout film-forming on the film-forming surface portion, and the substrate temperature was maintained at 450°C. A single crystal thin film of 1 cm$^2$ or greater and 3.5 μm thickness was obtained on the substrate. A critical current density of $2.3 \times 10^6$ A/cm$^2$ (77 K) and a Tco of 97 K were obtained.

Example 4

The substrate of Example 2 was changed to a single crystal of MgO (110) or SrTiO$_3$ (100). Then a magnetic field of 2T was applied on the film-forming surface portion, and the substrate temperature was maintained at 450°C. A single crystal thin film of about 5 mm$^2$ and 3 μm thickness was obtained on the substrate. A critical current density of $1.7 \times 10^6$ A/cm$^2$ parallel to the (ab) surface and a Tco of 95 K were obtained.

Example 5

In this example, a substrate with the superconducting oxide material made in Example 1 was heat annealed for 15 hours at a temperature of 300 to 500°C in an activated oxygen atmosphere of microwave plasma. At this time, the magnetic field 30-1 was applied by the device shown in Fig. 2 in the c axis direction of the previously prepared crystal surface. Also, the electric field 30-2 was applied at $10^3$ to $5 \times 10^4$ V/cm in the direction perpendicular to the magnetic field. As a result, it was found to be possible to improve the Tco even more by about 100 K, and 230 to 280 K was obtained. A critical current density of $6.0 \times 10^5$ A/cm$^2$ was also obtained.

In the practice of the present invention as above described, the material obtained is in the form of thin film. However, different forms can also be obtained, such as a film structure 3 to 30 μm thick, a band structure, or a wire structure (i.e., an elongate conductor structure) according to commercial requirements.

By using the above described apparatus according to the present invention, it has become possible to create a thin film superconducting oxide material having a high degree of crystal orderliners which exhibits superconductivity at temperatures equivalent to the temperature of liquid nitrogen or higher, a condition which up to now has been impossible to obtain. It is also possible to make a polycrystalline superconducting oxide thin film with uniform crystal orientation on the surface of an amorphous glass, silicon oxide, or silicon nitride substrate or the like. In the case where the growth of the crystal structure is in a direction in agreement with the substrate crystal axis, it is possible for the first time to utilize this material as a lead wire to enable electric connections to be made to the electrode sections of semiconductor integrated circuits without causing a disadvantageous direct oxidizing reaction with the semiconductor, because an oriented film can be obtained in accordance with the invention at a substrate temperature in the 200 to 500° C range.

In addition, in order to form a laminated polycrystalline structure comprising materials obtained as described in the foregoing, mixtures of various elements from Groups IIa and IIIa of the Japanese Periodic Table can be utilized. As shown in the present invention because a more uniform molecular arrangement can be obtained by applying a magnetic field during heating, it is possible to eliminate voids and reduce the height of barriers at crystal grain boundaries in the final compound, and in turn a higher Tco and Tc-onset can be obtained.

In accordance with an advantageous feature of the present invention which will be explained in the following, a reactive gas or reactive minute particles such as to impair the superconductive characteristics of the thin film material are added into the plasma, a mutual reaction is obtained in the plasma under the influence of a magnetic field, and this magnetic field is simultaneously applied to the film-forming surface portion thereby to obtaining a preferential crystal orientation during film-forming, such steps resulting in the formation of a crystalline, thin film non-superconducting material on the upper surface of the substrate. By subsequently forming a superconducting oxide material with the same crystal structure and crystal orientation as this non-superconducting material, a two-layer structure may be obtained in which both layers advantageously have the same coefficient of thermal expansion. By virtue of this two layer structure cracks and the like are not generated by the difference in coefficient of thermal expansion between the two-layer structure and the substrate, and even when cooling is applied to maintain the material at its active superconducting temperature, single crystals or polycrystals oriented in the direction of the specified crystal axis are produced.

In order to obtain a higher critical current density in such a superconducting thin film laminated on a non-superconducting material, reactive oxygen such as O, $O_3$, and the like, made with extremely high efficiency in the microwave plasma employed in manufacturing these thin films, is used as the reactive gas.

Since a mixed phase of the superconducting oxide material and the material of the film-forming surface portion can be formed if elementary particles of superconducting material impact the film-forming surface portion with high energy, as would be the case if a low frequency plasma CVD method at 1 KHz to 1 MHz was to be used, for example, therefore a high frequency (500 MHz to 10 GHz) microwave, typically 2.45 GHz, is used in the practice of the invention and the energy when the plasma is formed is not imparted to the reactive gas or particles as kinetic energy.

When the thin film of superconducting oxide material is produced a magnetic field for generating plasma is used simultaneously, so that the a, b or c axes of crystals with a modified perovskite structure as shown in Fig. 1, are oriented parallel or roughly parallel to the desired direction conforming to the application. By means of this magnetic field, the growing surfaces of the crystals are positioned in a uniform direction, and magnetic epitaxial growth occurs. In addition, in the case where single crystals are grown, magnetic epitaxial growth occurs. As a result, during the formation of the thin film, by the application of a magnetic field using 0.1 T or more, which is used for plasma creation during film forming, it becomes possible to orient the film at the film-forming surface portion. Simultaneously, the reactive gas or reactive particles are being mutually subjected to a plasma reaction in active oxygen or a gas containing active oxygen made by means of microwaves, and the superconducting oxide material reaction product forms film on the film-forming surface portion with the crystal axes in mutual agreement. By this method, the critical current density in the direction of, for example, the c surface (the surface parallel to the ab axis, specifically the ab surface) is improved to $1 \times 10^5$ A/cm$^2$ or greater (in this case, the ab surface can be in a direction parallel to the surface of the substrate).

In the practice of the invention including this feature, the superconducting oxide material and the method for manufacturing it may be the same as in the previously discussed embodiments, so further description thereof will be omitted. The additives used for forming non-superconducting films may be selected from the group including copper (Cu), the rare earth elements, iron (Fe), nickel (Ni), cobalt (Co). silicon (Si), germanium (Ge), boron (B), aluminium (Al), gallium (Ga), phosphorus (P), titanium (Ti), tantalum (Ta), and magnesium (Mg), used in an amount of 1 to 30 atomic %. Particularly useful elements are aluminium and magnesium. If these are added at 2 to 10 atomic % when an otherwise superconducting film is being formed, the superconducting properties of the film are spoiled and a film with non-superconducting characteristics is obtained. Then a superconducting film made without use of spoiling additives, that is to say a superconducting film with the same crystal structure and the same crystal orientation, is laminated to the top or bottom of the non-superconducting film so that there is no difference in the coefficients of thermal expansion and therefore no cracks are produced at the temperature of actual use.

In the examples hereinafter described, first the non-superconducting film is formed using the same principle as in the previous embodiments but with introduction of the spoiling additives then the superconducting film is formed and laminated to the non-superconducting film. In this manner, one crystal grain in the polycrystalline structure can become large, and, in turn, because adjacent crystals have the same crystal axis in common, the barriers at the crystal boundaries tend to disappear so that a single crystal structure can be obtained. By this means, the respective crystals can all be arranged in the ab surface (the surface perpendicular to the C surface). As a result, by the method of the present invention, a superconducting oxide material of the same structure as a non-superconducting material, but made without any additives, may be formed on the film of non-superconducting material, so that the critical current density , which up to the present has been $10^2$ A/cm$^2$ (77K) in the case of random crystal orientation, may be increased up to $10^4$ to $10^6$ A/cm$^2$ (measured at 77K) with the current flowing parallel to the ab surface, and can become equal in electric density to a single crystal or close to about the 1/5 level.

In the present invention, in producing a superconducting thin film with such an axis arrangement, a magnetic field is applied in a perpendicular or horizontal relationship with respect to the film-forming surface portion, and by the application of a microwave electric field perpendicular to the magnetic field to generate active oxygen, the temperature at which the film is formed is effectively lowered.

Further explanation will now be given with reference to specific examples, but basically the method of manufacturing these embodiments is the same as for previously-described Examples 1 to 5 except that prior to the formation of the superconducting film, the same method is used to produce the non-superconducting film except that additives which destroy the superconductivity are added to the organic solution of the elements which form the superconducting material. Explanation will be given in the following of the formation of the non-superconducting film only, and the explanation for the formation of the superconducting film will be omitted.

## Example 6

The method used in this example followed the method used for Example 1, except that a non-superconducting film was first formed by the use of additives to destroy the superconducting characteristics. The additives used were, for example, reactive gases, such a Al(C$_2$H$_5$)$_3$, Mg(C$_2$H$_5$)$_3$, and the like, and halogenated materials such as AlBr$_3$, MgBr$_2$, AlCl$_3$, MgCl$_2$, and the like. They were added to the solution of raw materials for producing the superconducting film in the prescribed quantities, for example, 10 atomic %. Oxygen was added to the mixed solutions by bubbling and these solutions were introduced to the plasma together with the oxygen.

The materials for manufacturing the non-superconducting oxide thin film were subjected to an activated dissociation reaction in the region of hybrid resonance, and the film was formed with its c axis aligned with the magnetic field perpendicular to the surface of the film-forming surface portion of the substrate 10.

The non-superconducting oxide film thus formed can be represented by the general expression IIIa$_{1-x}$X$_x$IIa$_{2-y}$Y$_y$Cu$_3$O$_{6-8}$, where x and y are the additives, with x = 0.01 to 0.3, y = 0.01 to 0.3. In this expression, X = Al, Y = Mg, x = 0.02, and y = 0.03. This material had a specific resistance of 3 x $10^4$ Ωcm and exhibited absolutely no superconductivity at the temperature of liquid nitrogen. The results of X-ray analysis clearly showed that this film had a modified perovskite structure with the c axis aligned in the same direction as the magnetic field.

## Example 7

The components used gave a material represented by the general expression Y$_{0.5}$Yb$_{0.5-x}$Al$_x$-BaSrCu$_3$O$_{6-8}$, where x = 0.01 to 0.3, for example, to give Y$_{0.5}$Yb$_{0.4}$Al$_{0.1}$BaSrCu$_3$O$_{6-8}$ when x = 0.1. Specifically, in the device of Fig. 2, the substrate 10 and substrate holder 10′ were positioned at right angles to the way they are shown in Fig. 2 (the surface of the substrate 10 was directed in the right-to-left direction in the drawing), and the temperature of the substrate was maintained at 500° C. In this way it was possible to form the ab surface of the non-superconducting oxide thin film in the perpendicular direction with the c axis parallel to the film-forming surface portion. As a result, a thin film of non-superconducting material with a modified perovskite structure was obtained on a film forming surface of a substrate of, for example, polycrystal such as glass, alumina, ZrO$_2$ and the like or of an amorphous structure. A specific resistance of $10^5$ Ωcm was obtained.

## Example 8

The substrate in Example 6 was changed to single crystals of MgO (100) or SrTiO$_3$ (100). Then a magnetic field of 2T was applied through the film on the film-forming surface portion and the temperature of the substrate was maintained at 450° C. A thin film of a non-superconducting oxide material represented by the general expression Y$_{0.9}$Al$_{0.1}$Ba$_2$Cu$_3$O$_{6-8}$ was formed on the substrate to a thickness of 3 μm. Then a thin film of a superconducting oxide material represented by the general expression YBa$_2$Cu$_3$O$_{6-8}$ was formed over the non-superconducting film to a thickness of 2 μm. In this way it was possible to obtain a single crystal thin film of 1 cm$^2$ or larger on the substrate. A critical current density of 3.3 x $10^6$ A/cm$^2$ (at 77K) and a Tco of 99 K were obtained. Because there was no thermal distortion in the base of the substrate, it could be assumed that this was an improved material.

## Example 9

The substrate in Example 6 was changed to single crystals of MgO (110) or SrTiO$_3$ (110). Then a magnetic field of 2T was applied throughout the film on the film-forming surface portion and the temperature of the substrate was maintained at 450° C. Then a single crystal superconducting thin film of about 5 mm$^2$ in size represented by the general expression YBa$_2$Cu$_3$O$_{6-8}$ was formed on the substrate to a thickness of 3 μm. Following this, a material represented by the general expression Y$_1$Ba$_{2-x}$Mg$_x$Cu$_3$O$_{6-8}$ where x = 0.01 to 0.3, for example Y$_1$Ba$_{1.9}$Mg$_{0.1}$Cu$_3$O$_{6-8}$ was formed to a thickness of 0.2 μm to give a protective film for the thin film of the non-superconducting oxide material.

A critical current density of 2.2 x $10^6$ A/cm$^2$ was obtained for the superconducting material in the direction parallel to the ab surface. A Tco of 97 K was obtained. In addition, a specific resistance of $10^4$ $\Omega$cm was obtained in the thin film of the non-superconducting material.

By means of the present invention, it has become possible to prepare a thin film of a non-superconducting oxide material having its crystal axes uniformly oriented and which can withstand usage at temperatures equivalent to or higher than the temperature of liquid nitrogen. This has previously been impossible. It has also become possible to prepare a thin film of a superconducting oxide material with the same crystal axes and same structure and prepared in substantially the same manner as the non-superconducting oxide material, and to laminate this superconducting oxide material to the top, bottom, or both sides of the non-superconducting oxide material. For this reason, even when subjected to change in temperature, this superconducting oxide material does not suffer thermal expansion distortion around its periphery where it joins the insulating material, but exhibits high reliability. It is also possible to fabricate an oriented polycrystalline oxide non-superconducting thin film on a surface of a substrate of an amorphous structure made of glass, silicon oxide, or silicon nitride and the like.

Superconducting ceramics for use in accordance with the present invention also may be prepared to be consistent with the stoichiometric formulae $(A_{1-x}B_x)_yCu_zO_w$, where A is one or more elements of Group IIIa of the Japanese Periodic Table, e.g., the rare earth elements, B is one or more elements of Group IIa of the Japanese Periodic Table, e.g., the alkaline earth metals including beryllium and magnesium, and $0 < x < 1$; $y = 2.0$ to $4.0$, preferably $2.5$ to $3.5$; $z = 1.0$ to $4.0$, preferably $1.5$ to $3.5$; and $w = 4.0$ to $10.0$, preferably $6.0$ to $8.0$. Also, superconducting ceramics for use in accordance with the present invention may be prepared to be consistent with the stoichiometric formulae $(A_{1-x}B_x)_yCu_zO_w$, where A is one or more elements of Group Vb of the Japanese Periodic Table such as Bi, Sb and As, B is one or more elements of Group IIa of the Japanese Periodic Table, e.g., the alkaline earth metals including beryllium and magnesium, and $x = 0.3$ to $1$; $y = 2.0$ to $4.0$, preferably $2.5$ to $3.5$; $z = 1.0$ to $4.0$, preferably $1.5$ to $3.5$; and $w = 4.0$ to $10.0$, preferably $6.0$ to $8.0$. Examples of this general formula are $BiSrCaCaCu_2O_x$ and $Bi_4Sr_3Ca_3Cu_4O_x$. Tc onset and Tco samples confirmed consistent with the formula $Bi_4Sr_yCa_3Cu_4O_x$ (y around 1.5) were measured to be 40 to 60 K, which is not so high. Relatively high critical temperatures were obtained with samples conforming to the stoichiometric formulae $Bi_4Sr_4Ca_2Cu_4O_x$ and $Bi_2Sr_3Ca_2Cu_2O_x$ where the number x designating the oxygen proportion is from 6 to 10, e.g. around 8.1.

## Claims

1. A method of forming a superconducting oxide material, said method comprising:
introducing oxygen or an oxidizing gas and a reactive gas or reactive minute particles into a plasma generating chamber;
applying a magnetic field to the plasma generating chamber and supplying microwave energy to the plasma generating chamber, the direction of the magnetic field and the propagation direction of the microwave energy being parallel;
the mutual reaction of the oxygen or the oxidizing gas and the reactive gas or reactive minute particles converting them to plasma; and
forming the superconducting oxide material by deposition of the plasma reaction products on a film forming surface portion positioned in or adjacent to the plasma generating chamber and subjected to the application of a magnetic field.

2. The method of claim 1, wherein the magnetic field for generating the plasma is applied in a direction perpendicular to or parallel to the film forming surface portion.

3. The method of Claim 1 or 2, wherein the superconducting material can be generally represented by the expression $(A_{1-x}B_x)_yCu_zO_w$, where $X = 0.1$ to $1$, $y = 2.0$ to $4.0$, $z = 1.0$ to $4.0$, and $w = 4.0$ to $10.0$;
A is one or more elements of the group comprising Y (yttrium), Gd (gadolinium), Yb (ytterbium), Eu (europium), Tb (terbium), Dy (dysprosium), Ho (holmium), Er (erbium), Tm (thulium), Lu (lutetium), Sc (scandium), and other lanthanides; and
B is one or more elements of the group comprising Ba (barium), Sr (strontium) and Ca (calcium).

4. An apparatus for forming a superconducting oxide material, said apparatus comprising:
a plasma generating chamber;
means for generating a magnetic field within the plasma generating chamber;
means for supplying microwave energy to the plasma generating chamber;
means for supplying a reactive gas or reactive minute particles and oxygen or an oxidizing gas to the plasma generating chamber for forming a superconducting oxide material as a plasma reaction product; and
means for forming the superconducting oxide material on a film-forming surface portion provided in the plasma generating chamber or in a region adjacent thereto, while applying a magnetic field or an electrical field thereto.

5. The apparatus of claim 4, wherein a means is provided for positioning the film-forming surface portion in a region with a stronger magnetic field.

6. The apparatus of claim 4 or 5, wherein the superconducting material can be generally represented by the expression $(A_{1-x}B_x)_yCu_zO_w$, where $x = 0.1$ to 1, $y = 2.0$ to 4.0, $z = 1.0$ to 4.0, and $w = 4.0$ to 10.0;

A is one or more elements of the group comprising Y (yttrium), Gd (gadolinium), Yb (ytterbium), Eu (europium), Tb (terium), Dy (dysprosium) Ho (holmium), Er (erbium), Tm (thulium), Lu (lutetium), Sc (scandium) and other lanthanides; and

B is one or more elements of the group comprising Ba (barium), Sr (strontium) and Ca (calcium).

7. A method of forming a superconducting oxide material comprising:

applying a magnetic field to the inside of a reaction chamber;

propagating microwave energy into the reaction chamber in substantially the same direction as the magnetic field;

generating a microwave excitation reaction wherein a superconducting material is formed in a resonance space by means of the resonance of the microwaves with a reactive gas or reactive minute particles in the magnetic field; and

growing crystals of the superconducting oxide material with the atomic arrangement of the crystals regulated by means of the magnetic field.

8. The method of claim 7 wherein the resonance is a hybrid resonance.

9. The method of claim 7 or 8, wherein the crystal growth is carried out on a surface positioned substantially at right angles to the magnetic field.

10. A method of forming a superconducting oxide material wherein first a film with non-superconducting characteristics is formed from the same main constituents as the superconducting oxide material, said method comprising:

the introduction into a plasma generating chamber of oxygen or an oxidizing gas and a reactive gas or reactive minute particles for forming a superconducting oxide material;

the introduction into the plasma generating chamber of a reactive gas or reactive minute particles as an additive for destroying the superconducting characteristics of the superconducting oxide material;

the application of a magnetic field to the plasma generating chamber;

the supplying of microwave energy to the plasma generating chamber;

the mutual reaction of the oxygen or oxidizing gas and reactive gas or reactive minute particles, and of the additive reactive gas or additive reactive minute particles converting them to a plasma;

the formation of a film having non-superconducting characteristics on a film-forming surface portion positioned in or adjacent to the plasma generating chamber and subject to the application of a magnetic field, the non-superconducting film having the same major constituents as the required superconducting oxide material and further including the additive for destroying the superconducting characteristics; and

the formation of a superconducting oxide material contiguous to the non-superconducting film by repetition of the above-mentioned process with the omission of the additive for destroying the superconducting characteristics.

11. The method of claim 10, wherein the superconducting material can be generally represented by the expression $(A_{1-x}B_x)_yCu_zO_w$, where $x = 0.1$ to 1, $y = 2.0$ to 4.0, $z = 1.0$ to 4.0, and $w = 4.0$ to 10.0;

A is one or more elements selected from the group comprising Y (yttrium), Gd (gadolinium), Yb (ytterbium), Eu (europium), Tb (terbium), Dy (dysprosium), Ho (holmium), Er (erbium), Tm (thulium), Lu (lutetium), Sc (scandium) and other lanthanides; and

B is one or more elements selected from the group comprising Ba (barium), Sr (strontium) and Ca (calcium).

12. The method of claim 10 or 11, wherein the additive is selected from the group of elements comprising copper (Cu), the rare earth elements, iron (Fe), nickel (Ni), cobalt (Co), silicon (Si), germanium (Ge), boron (B), aluminium (Al), gallium (Ga), phosphorus (P), titanium (Ti), tantalum (Ta), and magnesium (Mg).

13. The method of claim 10 or 11 or 12, wherein the film is formed without the introduction of a reactive gas or reactive minute particles which act as an additive, in order to cause a film with crystal axes of uniform orientation and with the same crystal structure as the superconducting oxide material to form on the top or bottom side of the non-superconducting film.

14. A method of forming a superconducting film, said method comprising forming a non-superconducting film of substantially the same crystalline structure as the required superconducting film, and then forming the superconducting film on the surface of the non-superconducting film.

15. A method of forming a superconducting film by deposition of plasma reaction products upon a film-forming surface, said method including introducing an additive into the plasma so as to spoil the superconducting properties of the deposited film, and thereafter depositing a superconducting film formed without the additive.

16. A method of forming a thin film superconducting material, said method comprising reacting reactive gases and/or reactive minute particles in a plasma, and depositing plasma reaction products upon a surface subject to a magnetic and/or electric field so as to obtain a preferred crystal orientation during formation of the film.

17. A method according to claim 16 wherein the plasma is generated under the influence of a magnetic field and with the injection of microwave energy.

18. A method according to claim 16 or 17, wherein the materials for constituting the superconducting material are introduced into the plasma in the form of an aerosol or spray comprising organic compounds of the constituent elements of the superconducting material, or comprising salts of the constituent elements, or comprising finely divided preformed superconducting material.

19. A method of formation of a thin superconducting oxide film by deposition of plasma reaction products upon a surface which is subjected to a magnetic field in a predetermined direction and to a microwave electric field in a direction orthogonal to the magnetic field direction.

20. A method of manufacturing a superconducting thin film material which comprises the deposition of a polycrystalline material by a CVD process and further includes thermal treatment of the deposited material under the application of a magnetic and/or electric field and within an atmosphere comprising the superconducting material in a dissociated form so as to encourage substantially unidirectional crystal growth in the polycrystalline material whereby a quasi-single-crystal structure may be obtained.

21. An apparatus for manufacturing a superconducting material comprising a plasma generation chamber, means for developing a magnetic field within the chamber and for propagating microwave energy within the chamber so as to develop a hybrid resonance within the plasma chamber, means for introducing reaction gases and basic reaction products into said chamber for the development of a plasma reaction within the chamber and the formation of reaction products such as when deposited upon a substrate to form a superconducting layer, a substrate holder within said chamber in or adjacent to the plasma generation region, and means for applying a magnetic and/or electric field to the deposition region of the substrate for developing a preferential orientation in the deposited material.

# FIG.1

$(YBa_2)Cu_3O_{7-x}$

# FIG.2